Europäisches Patentamt

European Patent Office

Office européen des brevets

(11) Publication number: 0 368 311
A2

# EUROPEAN PATENT APPLICATION

(21) Application number: 89120789.6

(22) Date of filing: 09.11.89

(51) Int. Cl.5: C30B 7/00, C30B 29/18

(30) Priority: 10.11.88 JP 282410/88

(43) Date of publication of application:
16.05.90 Bulletin 90/20

(84) Designated Contracting States:
DE FR GB

(71) Applicant: NITTO CHEMICAL INDUSTRY CO.,
LTD.
No. 5-1, Marunouchi 1-chome Chiyoda-ku
Tokyo(JP)

(72) Inventor: Orii, Koichi
8-904, Wakabadai-2-chome
Asahi-ku Yokohama(JP)
Inventor: Ohshima, Iwao
10-1-108, Ichibakamicho
Tsurumi-ku Yokohama(JP)
Inventor: Owaku, Mutsuo
23-18, Higashihatsutomi 5-chome
Kamagaya-shi(JP)

(74) Representative: Hansen, Bernd, Dr.rer.nat. et
al
Hoffmann, Eitle & Partner Patentanwälte
Arabellastrasse 4 Postfach 81 04 20
D-8000 München 81(DE)

(54) Process for producing micro cultured quartz.

(57) A process for producing micro cultured quartz comprising using microparticle-shaped cristobalite as a raw material in producing cultured quartz according to a hydrothermal growth method. According to the present invention, micro cultured quartz can be obtained without a pulverizing treatment and hence without the contamination with impurities therein. The micro cultured quartz can be utilized for reinforcing fillers, spacers, raw materials of fused quartz and the like.

## PROCESS FOR PRODUCING MICRO CULTURED QUARTZ

The present invention relates to a process for producing micro cultured quartz.

In the present invention, the micro cultured quartz is micro artificial quartz having the main axis of 1 mm or less.

Cultured quartz is stable physically and chemically and excellent in mechanical properties and stability of oscillation frequency. Therefore, large cultured quartz has been widely used as a material of an oscillator. Small cultured quartz has been, however, little utilized in the existing circumstances.

Micro cultured quartz obtained according to the present invention has the same properties such as strength, transparency, anisotropy of shape, heat conductivity and the like as single crystal cultured quartz has, and is expected to be utilized for reinforcing fillers, spacers, raw materials of fused quartz and the like.

As a process for producing cultured quartz, a hydrothermal growth method is usually adopted. The hydrothermal growth method is, for example, described in Journal of the Ceramic Association Japan, 77 (4), 111-123 (1969). A process comprising preparing an aqueous solution in high concentration at a high temperature and a high pressure including a proper mineralizer from a crystalline substance insoluble or quite hard to be soluble at an ordinary temperature and accelerating the growth of a seed crystal utilizing the difference of solubility depending on temperature is referred to as a hydrothermal growth of crystals (hereinafter referred to as hydrothermal growth method). In case of the growth of cultured quartz, there is used the hydrothermal temperature difference method wherein a temperature difference is made between the top and bottom parts of an aqueous solution at a high temperature and a high pressure; a raw material is dissolved in the bottom part (high temperature part) and the solute is deposited on seed crystal in the top part (low temperature part) to allow crystal to grow.

As raw materials for the production of the cultured quartz, there have been heretofore used scrapped rock crystal, lasca and the like.

In the production of the cultured quartz, heretofore, a restricted number of pieces, for example, from several to several tens pieces of seed crystal are used as starting materials, growing at a slow pace, in order to obtain large crystal free of structural defects. In said production, the formation of cultured quartz small in size is not desirable and hence there has been no concept of obtaining a large amount of micro cultured quartz.

The formation of single crystal of cultured quartz consists of a process of the appearance of crystal nuclei and a process of the growth of crystals from the nuclei as stating points. In order to obtain a large number of pieces of micro cultured quartz, it is necessary to allow a large number of crystal nuclei to appear and allow crystals to grow independently from respective crystal nuclei.

The present inventors have eagerly investigated to solve the above-mentioned problems and found that microparticle-shaped cristobalite can be surprisingly converted to a large number of pieces of micro cultured quartz by carrying out the hydrothermal growth method using microparticle-shaped cristobalite as a raw material for the appearance of crystal nuclei and the growth of crystals.

The present invention relates to a process for producing micro cultured quartz comprising using microparticle-shaped cristobalite as a raw material in producing cultured quartz according to a hydrothermal growth method.

An object of the present invention is to obtain easily a large number of pieces of micro cultured quartz.

Other objects and advantages of the invention will become apparent from the following description.

In the present invention, a purity of the microparticle-shaped cristobalite used as the raw material is not particularly restricted. However, in order to raise the purity of micro cultured quartz to be formed, there is preferably used microparticle-shaped cristobalite having as small an amount of impurities as possible.

A process for producing the microparticle-shaped cristobalite is not restricted. There can be used microparticle-shaped cristobalite obtained by heating natural or synthetic amorphous silica, or one obtained by heating amorphous silica to which a substance such as alkali or the like accelerating a conversion to cristobalite has been added in advance.

For example, the microparticle-shaped cristobalite can be obtained by heating amorphous silica having a specific surface area of 50 $m^2/g$ or more measured according to BET method at a temperature of from 1000°C to 1300°C in the presence of 5 - 600 ppm of an alkali metal. The BET method is a method of calculating a specific surface area of a solid material using BET adsorption isotherm.

The microparticle-shaped cristobalite preferably has an average particle size of 1 mm or less, more preferably 0.5 mm or less, further preferably 0.3 mm or less. When the average particle size is more than 1 mm, a number of crystal nuclei appears on a particle and the obtained crystal undesirably becomes polycrystalline. Even if a single crystal grows, it is not suitable for a raw material of a large number of pieces of micro cultured quartz.

Microparticle-shaped cristobalite having an average particle size of 1 mm or less can be prepared by pulverizing a lump of cristobalite or by heating as stated above amorphous silica having an average particle size of 1 mm or less.

Using the obtained microparticle-shaped cristobalite as a raw material, the process of the growth of micro cultured quartz is conducted.

Generally, the process of the growth of the cultured quartz is conducted according to a hydrothermal temperature difference method comprising charging a siliceous material in the bottom part of a vertical autoclave (hereinafter the part being referred to as the solution part in some places), hanging a seed crystal in the top part thereof (hereinafter referred to as the growth part in some places), pouring 75% - 85% by volume based on the inner volume of the autoclave of an aqueous alkali solution into the autoclave and setting a temperature difference between the top and bottom parts by means of heating in a hermetically sealed state thereby maintaining the solution part at a high temperature and the growth part at a low temperature.

In the present invention, said siliceous material is microparticle-shaped cristobalite, and the seed crystal is not necessarily required. Also, a volume of said aqueous alkali solution can be reduced to be about 65% of the inner volume of the autoclave.

Since the inner part of the autoclave becomes in a state of high temperature and high pressure, there should be used an autoclave standing a pressure of preferably from 1000 - 1500 atm.

In the solution part, the microparticle-shaped cristobalite as the siliceous material is dissolved in the aqueous alkali solution to form a saturated solution of $SiO_2$. The saturated solution rises due to a convection owing to a temperature difference between the top and bottom parts of the autoclave, and enters in the top part of a low temperature of the autoclave to form a supersaturation solution of $SiO_2$.

Although a mechanism of the appearance of the crystal nuclei in the present invention has not yet been cleared, there are proposed two possible mechanisms that a part of the particle of the microparticle-shaped cristobalite is converted to $\alpha$ quartz on account of a dislocation and the $\alpha$ quartz grows, and that a crystal of $SiO_2$ deposited from the above-mentioned supersaturation solution serves as a crystal nucleus and the nucleus grows.

A temperature in the hydrothermal growth method is usually in a range of from 300°C to 400°C. A temperature difference between the top and bottom parts of the autoclave is usually in a range of from 20°C to 40°C. When the temperature is more than 400°C, a uniform product is hard to be obtained.

Incidentally, in the present invention, the temperature can be also in a range of from about 250°C to 300°C and further the temperature difference is not always necessary.

A growth time is in a range of from one day to 14 days.

As solutes of the aqueous alkali solution, that is, as mineralizers, there can be used at least one selected from the group consisting of hydroxides, carbonates, hydrogencarbonates, borates, phosphates, acetates, halides and fatty acid salts of alkali metals such as Li, Na, K and the like.

Incidentally, when the microparticle-shaped cristobalite is obtained by heating amorphous silica in the presence of an alkali metal, the used alkali metal remains in the obtained microparticle-shaped cristobalite. Therefore, in the hydrothermal growth method, it is preferable to use the aqueous alkali solution of the same alkali metal as in the production of the microparticle-shaped cristobalite.

According to the present invention, the micro cultured quartz can be obtained without a pulverizing treatment and hence without the contamination with impurities therein.

The present invention is explained more specifically below referring to the following Examples and Comparative Examples. However, the present invention should not be construed to be restricted to the Examples.

EXAMPLE 1

Micro cultured quartz was produced as follows according to a hydrothermal temperature difference method.

In the bottom part of an autoclave, there was charged, as a raw material, 10 g of silica having an average particle size of 200 μm and a density of 2.33 g/cm³, containing 100 ppm of Na and 1 ppm or less of each of Al, Ti, Li and K and proving to have cristobalite structure from an X-ray diffraction measurement. 75% by volume based on the inner volume of the autoclave of 1N aqueous $Na_2CO_3$ solution was charged into the autoclave. No seed crystal was used.

The autoclave was allowed to stand for 7 days at 280°C in the bottom part where the raw material was dissolved and at 270°C in the top part where a supersaturation solution was formed.

The obtained products were separated into solid and liquid matter. As a result, 5.6 g of powdery solid was obtained.

The obtained powdery solid proved to be cultured quartz from an X-ray diffraction measurement. It further proved to be micro cultured quartz having the minor axis of 10-40 μm and the major axis of about 100 μm.

COMPARATIVE EXAMPLE 1

Cultured quartz was produced in the same manner as in Example 1, except that there was used as the raw material a lump of cristobalite having a size of mm in place of the silica having an average particle size of 200 μm.

The obtained products were scarcely single crystals but polycrystals of α quartz.

EXAMPLE 2

Micro cultured quartz was produced as follows according to a hydrothermal temperature difference method.

In the bottom part of an autoclave, there was charged, as a raw material, 20 g of silica having an average particle size of 100 μm and a density of 2.33 g/cm$^3$, containing 40 ppm of Na and 1 ppm or less of each of Al, Ti, Li and K and proving to have cristobalite structure from an X-ray diffraction measurement. 60% by volume based on the inner volume of the autoclave of 1N aqueous NaOH solution was charged into the autoclave. No seed crystal was used.

The autoclave was allowed to stand for 10 days at 380°C in the bottom part where the raw material was dissolved and at 350°C in the top part where a supersaturation solution was formed.

The obtained products were separated into solid and liquid matter. As a result, powdery solid was obtained.

The obtained powdery solid proved to be cultured quartz from an X-ray diffraction measurement. It further proved to be micro cultured quartz having the minor axis of 20-50 μm and the major axis of about 100 μm.

Claims

1. A process for producing micro cultured quartz comprising using microparticle-shaped cristobalite as a raw material in producing cultured quartz according to a hydrothermal growth method.

2. A process for producing micro cultured quartz according to Claim 1, wherein the average particle size of the microparticle-shaped cristobalite is 1 mm or less.

3. A process for producing micro cultured quartz according to Claim 1, wherein the average particle size of the microparticle-shaped cristobalite is 0.5 mm or less.

4. A process for producing micro cultured quartz according to Claim 1, wherein the average particle size of the microparticle-shaped cristobalite is 0.3 mm or less.

5. A process for producing micro cultured quartz according to any of Claims 1 - 4, wherein there is used microparticle-shaped cristobalite obtained by heating amorphous silica having a specific surface area of 50 m$^2$/g or more measured according to BET method at a temperature of from 1000°C to 1300°C in the presence of 5 - 600 ppm of an alkali metal, the BET method being a method of calculating a specific surface area using BET adsorption isotherm.